# FASCICULE DE BREVET EUROPEEN

(11) **EP 3 247 954 B1**
(45) Date de publication et mention de la délivrance du brevet: **11.03.2020**
(21) Numéro de dépôt: 16700964.6
(22) Date de dépôt: 18.01.2016
(51) Int. Cl.: F24H 3/04, F24H 9/20, B60H 1/22, H05K 1/02, H05K 3/46

(54) **RADIATEUR ELECTRIQUE ADDITIONNEL POUR VEHICULE AUTOMOBILE**
ZUSÄTZLICHER ELEKTRISCHER HEIZKÖRPER FÜR KRAFTFAHRZEUG
ADDITIONAL ELECTRIC RADIATOR FOR MOTOR VEHICLE

(30) Priorité: 21.01.2015 FR 1550467
(43) Date de publication de la demande: 29.11.2017
(73) Titulaire: Valeo Systemes Thermiques, 78320 Le Mesnil Saint Denis (FR)
(72) Inventeur: PUZENAT, Bertrand, 78322 Le Mesnil Saint-Denis Cédex (FR); KARAASLAN, Serif, 78322 Le Mesnil Saint-Denis Cédex (FR)
(74) Mandataire: Metz, Gaëlle
(86) Numéro de dépôt international: PCT/EP2016/050872
(87) Numéro de publication internationale: WO 2016/116391

(56) Documents cités:
- EP-A2- 0 534 290
- WO-A1-2012/019854
- WO-A1-2014/154581

## Description

L'invention concerne un radiateur électrique additionnel pour véhicule automobile, alimenté par batterie, et disposé dans le bloc de climatisation du véhicule automobile.

Un tel radiateur additionnel se présente sous la forme générale d'un parallélépipède rectangle relativement plat, dont la grande face est disposée perpendiculairement au flux d'air à réchauffer. Usuellement, les éléments chauffants sont placés dans le flux d'air, et l'électronique de commande des éléments chauffants est regroupée sur un côté du radiateur électrique additionnel, en dehors des éléments chauffants.

L'électronique de commande reçoit des données de consigne d'un calculateur superviseur, et assure la commande des éléments chauffants au moyen de transistors de puissance et d'un circuit faisant le lien entre les données de consigne et la commande des transistors de puissance.

L'électronique de commande est usuellement disposée sur un support de circuit imprimé de forme sensiblement rectangulaire, logé dans l'enveloppe du radiateur électrique additionnel.

Selon un premier mode de réalisation de l'art antérieur, le support de circuit imprimé est disposé sensiblement dans le plan moyen du radiateur électrique additionnel, c'est-à-dire, dans le plan moyen des éléments chauffants. Compte tenu des contraintes de dimensions du bloc de climatisation du véhicule, la surface occupée par le support de circuit imprimé réduit la surface dévolue au réchauffement du flux d'air par les éléments chauffants du radiateur électrique additionnel.

Pour éviter cet inconvénient, selon un deuxième mode de réalisation de l'art antérieur, le support de circuit imprimé est disposé sensiblement perpendiculairement au plan moyen du radiateur électrique additionnel. La surface disponible pour le réchauffement du flux d'air est alors maximale, mais l'enveloppe du radiateur électrique additionnel comporte une excroissance latérale pour abriter le support de circuit imprimé, ce qui la rend plus difficile à loger dans le bloc de climatisation du véhicule automobile.

Un but de l'invention est de proposer un radiateur électrique additionnel ne présentant pas les inconvénients précités.

Un autre but de l'invention est de proposer un radiateur électrique additionnel dans lequel l'encombrement transversal de l'enveloppe du radiateur électrique additionnel est limité, et la zone dévolue au réchauffement du flux d'air est optimisée. Le document WO 2014/154581 A1 divulgue un radiateur électrique additionnel pour véhicule automobile selon les caractéristiques du préambule de la revendication 1.

L'invention a pour objet un radiateur électrique additionnel pour véhicule automobile, comportant une zone de chauffe et un compartiment logeant des composants électroniques de contrôle du chauffage, lesdits composants électroniques étant disposés sur un support de circuit imprimé, caractérisé en ce que le support de circuit imprimé, d'une part présente une zone longitudinale de fraisage partiel, d'autre part est plié en cornière selon ladite zone de fraisage partiel, et en ce que le support de circuit imprimé présente une première et une deuxième zones longitudinales séparées par la zone de fraisage partiel, la première zone longitudinale de support de circuit imprimé portant des composants électroniques de forte puissance.

De manière avantageuse, la couche extérieure de cuivre du support de circuit imprimé assure la liaison mécanique de l'ensemble des zones longitudinales et de la zone de fraisage partiel du support de circuit imprimé.

Avantageusement, la première zone longitudinale du support de circuit imprimé est placée perpendiculairement au plan moyen du radiateur, à proximité de la zone de chauffe.

Avantageusement, les composants électroniques de forte puissance sont des transistors de puissance, les connexions aux éléments chauffants de la zone de chauffe, les connexions à la batterie du véhicule.

De manière avantageuse, la deuxième zone longitudinale du support de circuit imprimé est placée parallèlement au plan moyen du radiateur.

Avantageusement, la deuxième zone longitudinale du support de circuit imprimé porte les composants électroniques de faible puissance.

De manière avantageuse, la zone longitudinale de fraisage partiel est sensiblement médiane.

D'autres caractéristiques et avantages de l'invention ressortent de la description qui suit faite avec référence aux dessins annexés dans lesquels :
La figure 1 est une vue de côté d'un radiateur électrique additionnel selon un premier mode de réalisation de l'art antérieur, dans lequel le support de circuit imprimé est disposé sensiblement dans le plan moyen du radiateur électrique additionnel ;
La figure 2 est une vue de côté d'un radiateur électrique additionnel selon un deuxième mode de réalisation de l'art antérieur, dans lequel le support de circuit imprimé est disposé sensiblement perpendiculairement au plan moyen du radiateur électrique additionnel ;
La figure 3 est une vue de côté d'un radiateur électrique additionnel selon un mode de réalisation de l'invention.

D'une manière générale, un radiateur électrique additionnel 1 pour véhicule automobile se présente sous la forme générale d'un parallélépipède rectangle relativement plat, avec une grande face 2 traversée par un flux d'air 3 à réchauffer. L'ensemble du radiateur 1 comprend essentiellement une zone de chauffe 4 à éléments chauffants, et un compartiment 5 comprenant l'électronique de commande des éléments chauffants de la zone de chauffe 4. Le compartiment 5 comprend un support 6 de circuit imprimé, portant des composants électroniques, des connexions 7 à la batterie, et des connexions 8 aux éléments chauffants de la zone de chauffe 4. Les composants électroniques portés par le support 6 de circuit imprimé sont d'une part des transistors de puissance pour assurer le chauffage des éléments chauffants, d'autre part des composants de commande et de régulation du chauffage à partir des données de consigne.

Le support 6 de circuit imprimé est une plaque rectangulaire, dont la longueur est sensiblement celle du radiateur 1, et dont la largeur est sensiblement le double de l'épaisseur du radiateur 1.

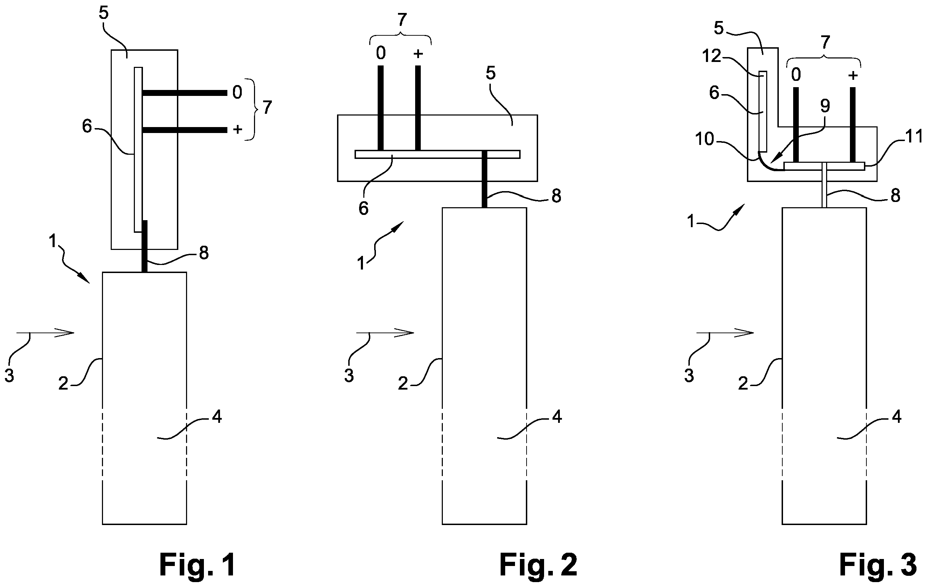

Dans le premier mode de réalisation de l'art antérieur (figure 1), le support 6 de circuit imprimé est disposé dans le plan moyen du radiateur 1, ce qui impose de limiter la hauteur de la zone de chauffe 4 pour pouvoir loger l'ensemble du radiateur 1 dans le bloc de climatisation du véhicule automobile.

Dans le deuxième mode de réalisation de l'art antérieur (figure 2), le support 6 de circuit imprimé est disposé perpendiculairement au plan moyen du radiateur 1, ce qui permet d'augmenter la hauteur de la zone de chauffe 4. Cependant, l'excroissance latérale du compartiment 5 par rapport à l'épaisseur de la zone de chauffe 4 impose une contrainte supplémentaire pour le logement du radiateur 1 dans le bloc de climatisation du véhicule automobile.

Selon l'invention, le support 6 de circuit imprimé est soumis à un fraisage partiel le long d'une zone longitudinale. Le fraisage partiel assure une réduction de l'épaisseur du support 6 de circuit imprimé à la seule couche de cuivre 10 de revêtement extérieur. Après cette opération de fraisage, le support 6 de circuit imprimé présente deux zones longitudinales 11 et 12, séparées par une zone 9 de fraisage partiel, la couche extérieure de cuivre 10 du support 6 de circuit imprimé assurant la liaison mécanique de l'ensemble. Selon l'invention, les composants sont alors mis en place sur le support 6 de circuit imprimé, en fonction de leur puissance. Sur la première zone longitudinale 11 sont disposés les composants électroniques de forte puissance : les transistors de puissance, les connexions 8 aux éléments chauffants, les connexions 7 à la batterie du véhicule automobile. Sur la deuxième zone longitudinale 12 sont disposés les composants électroniques de faible puissance : les composants électroniques assurant l'acquisition des données de consigne, l'émission des signaux de commande et de régulation du chauffage, le contrôle des protections en tension et en température, éventuellement au moyen d'un microcontrôleur. Entre les deux zones longitudinales 11 et 12, les signaux qui transitent sont essentiellement des signaux de commande des transistors de puissance.

Une fois l'implantation des composants réalisée, le support 6 de circuit imprimé est plié selon la zone 9, de façon à placer les deux zones longitudinales 11 et 12 sensiblement à 90° l'une de l'autre, la couche de cuivre 10 étant à l'extérieur. La première zone longitudinale 11 portant les composants électroniques de forte puissance est placée perpendiculairement au plan moyen du radiateur 1, à proximité et le plus près possible des éléments chauffants de la zone de chauffe 4. La deuxième zone longitudinale 12 portant les composants électroniques de faible puissance est alors placée parallèlement au plan moyen du radiateur 1 (figure 3).

Avec cette disposition du support 6 du circuit imprimé, la hauteur de la zone de chauffe 4 est optimisée et proche du cas de la figure 2 (support 6 de circuit imprimé perpendiculaire au plan moyen du radiateur1).

De son côté, l'encombrement latéral du compartiment 5 est lui aussi optimisé et proche du cas de la figure 1 (support 6 de circuit imprimé dans le plan moyen du radiateur 1).

Du fait du pli à 90° et de sa disposition générale en cornière, le support 6 de circuit imprimé occupe un encombrement réduit et n'empiète pratiquement pas sur la zone de chauffe. Le compartiment 5 a des dimensions limitées tant dans le plan moyen du radiateur 1 que dans le plan perpendiculaire audit plan moyen.

Il n'empiète pas de manière sensible sur la zone de chauffe 4 et il ne déborde pas transversalement de manière sensible de la zone de chauffe 4. A l'intérieur du compartiment 5, la couche extérieure de cuivre 10 assure la liaison mécanique de l'ensemble des zones longitudinales 11, 12 et de la zone de fraisage 9 partiel du support 6 de circuit imprimé.

## Revendications

1. Radiateur électrique additionnel pour véhicule automobile, comportant une zone (4) de chauffe et un compartiment (5) logeant des composants électroniques de contrôle du chauffage, lesdits composants électroniques étant disposés sur un support (6) de circuit imprimé, **caractérisé en ce que** le support (6) de circuit imprimé, d'une part présente une zone (9) longitudinale de fraisage partiel, d'autre part est plié en cornière selon ladite zone (9) de fraisage partiel, le support (6) de circuit imprimé présente une première (11) et une deuxième (12) zones longitudinales séparées par la zone (9) de fraisage partiel, la première zone longitudinale (11) de support (6) de circuit imprimé portant des composants électroniques de forte puissance.

2. Radiateur selon la revendication 1, **caractérisé en ce que** la couche extérieure de cuivre (10) du support (6) de circuit imprimé assure la liaison mécanique de l'ensemble des zones longitudinales (11, 12) et de la zone (9) de fraisage partiel du support (6) de circuit imprimé.

3. Radiateur selon la revendication 2, **caractérisé en ce que** la première zone longitudinale (11) du support (6) de circuit imprimé est placée perpendiculairement au plan moyen des éléments chauffants du radiateur (1), à proximité de la zone de chauffe (4).

4. Radiateur selon l'une des revendications 1 à 3, **caractérisé en ce que** les composants électroniques de forte puissance sont des transistors de puissance, les connexions (8) aux éléments chauffants de la zone de chauffe (4), les connexions (7) à la batterie du véhicule.

5. Radiateur selon l'une des revendications 1 à 4, **caractérisé en ce que** la deuxième zone longitudinale (12) du support (6) de circuit imprimé est placée parallèlement au plan moyen des éléments chauffants du radiateur (1).

6. Radiateur selon la revendication 5, **caractérisé en ce que** la deuxième zone longitudinale (12) du support (6) de circuit imprimé porte des composants électroniques de faible puissance.

## Patentansprüche

1. Zusätzlicher elektrischer Heizkörper für ein Kraftfahrzeug, der eine Heizzone (4) und ein Abteil (5) aufweist, in dem elektronische Steuerbauteile der Heizung untergebracht sind, wobei die elektronischen Bauteile auf einem Leiterplattenträger (6) angeordnet sind, **dadurch gekennzeichnet, dass** der Leiterplattenträger (6) einerseits eine teilweise gefräste Längszone (9) aufweist, andererseits winkelmäßig gemäß der teilweise gefrästen Zone (9) umgebogen ist, der Leiterplattenträger (6) eine erste (11) und eine zweite (12) Längszone aufweist, die durch die teilweise gefräste Zone (9) getrennt sind, wobei die erste Längszone (11) des Leiterplattenträgers (6) elektronische Bauteile hoher Leistung trägt.

2. Heizkörper nach Anspruch 1, **dadurch gekennzeichnet, dass** die äußere Kupferschicht (10) des Leiterplattenträgers (6) die mechanische Verbindung der Gesamtheit der Längszonen (11, 12) und der teilweise gefrästen Zone (9) des Leiterplattenträgers (6) gewährleistet.

3. Heizkörper nach Anspruch 2, **dadurch gekennzeichnet, dass** die erste Längszone (11) des Leiterplattenträgers (6) lotrecht zur Mittelebene der Heizelemente des Heizkörpers (1) in der Nähe der Heizzone (4) angeordnet ist.

4. Heizkörper nach einem der Ansprüche 1 bis 3, **dadurch gekennzeichnet, dass** die elektronischen Bauteile hoher Leistung Leistungstransistoren, die Verbindungen (8) mit den Heizelementen der Heizzone (4), die Verbindungen (7) mit der Batterie des Fahrzeugs sind.

5. Heizkörper nach einem der Ansprüche 1 bis 4, **dadurch gekennzeichnet, dass** die zweite Längszone (12) des Leiterplattenträgers (6) parallel zur Mittelebene der Heizelemente des Heizkörpers (1) angeordnet ist.

6. Heizkörper nach Anspruch 5, **dadurch gekennzeichnet, dass** die zweite Längszone (12) des Leiterplattenträgers (6) elektronischer Bauteile schwacher Leistung trägt.

## Claims

1. Additional electric radiator for a motor vehicle, including a heating zone (4) and a compartment (5) housing electronic components for controlling the heating, said electronic components being arranged on a printed circuit board (6), **characterized in that** the printed circuit board (6) has a longitudinal partially milled zone (9) and is folded at an angle along said partially milled zone (9), the printed circuit board (6) has first (11) and second (12) longitudinal zones that are separated by the partially milled zone (9), the first longitudinal zone (11) of the printed circuit board (6) bearing high-power electronic components.

2. Radiator according to Claim 1, **characterized in that** the outer, copper layer (10) of the printed circuit board (6) provides the mechanical connection for the assembly of the longitudinal zones (11, 12) and the partially milled zone (9) of the printed circuit board (6).

3. Radiator according to Claim 2, **characterized in that** the first longitudinal zone (11) of the printed circuit board (6) is positioned perpendicular to the mean plane of the heating elements of the radiator (1), in proximity to the heating zone (4).

4. Radiator according to one of Claims 1 to 3, **characterized in that** the high-power electronic components are power transistors, the connections (8) to the heating elements of the heating zone (4) and the connections (7) to the battery of the vehicle.

5. Radiator according to one of Claims 1 to 4, **characterized in that** the second longitudinal zone (12) of the printed circuit board (6) is positioned parallel to the mean plane of the heating elements of the radiator (1).

6. Radiator according to Claim 5, **characterized in that** the second longitudinal zone (12) of the printed circuit board (6) bears low-power electronic components.
